# EUROPEAN PATENT APPLICATION

(11) **EP 2 509 103 A1**
(43) Date of publication of application: **10.10.2012**
(21) Application number: 11160939.2
(22) Date of filing: 04.04.2011
(51) Int. Cl.: H01L 21/48, H01L 23/36

(54) **Apparatus and method for thermal connection**

(71) Applicant: ABB Oy, 00380 Helsinki (FI)
(72) Inventor: Seväkivi, Pertti, 01830, Lepsämä (FI); Leppänen, Ora Veli-Matti, 5404, Baden (CH); Koivuluoma, Timo, 01710, Vantaa (FI); Elo, Markku, 02750, Espoo (FI)
(74) Representative: Holmström, Stefan Mikael

(57) **Abstract**

The invention relates to an apparatus (1'), comprising: at least one semiconductor (2) arranged on a base plate (3), and an element (4) with a surface arranged to contact a surface of the base plate for receiving a heat load generated by said at least one semiconductor (2) device. In order to ensure that heat is efficiently transferred from the base plate to the element (4), at least one of said surfaces (9, 10) is provided with a plurality of protrusions (6) which at least partly penetrate into the other one of said surfaces (9, 10).

## Description

### BACKGROUND OF THE INVENTION

### FIELD OF THE INVENTION

This invention relates to a solution for ensuring sufficient cooling of a semiconductor.

### DESCRIPTION OF PRIOR ART

The amount of heat generated by a semiconductor is often of such an extent that the heat needs to be transferred away from the semiconductor and the base plate to which the semiconductor is arranged in order to avoid malfunctions caused by a rise in the temperature.

Though many materials with excellent heat transfer capabilities are known, a problem is often the interfaces between the different parts of an apparatus. At such interfaces two different parts of the apparatus have been arranged in such a way that their surfaces contact each other in order to transfer heat from one part to another. However, if a sufficient contact has not been achieved between the surfaces, the heat cannot be efficiently transferred over the interface between the parts.

One known solution is to arrange thermal grease between surfaces of parts to ensure that sufficient heat transfer is obtained over the interface between these parts. However, such thermal grease contains chemical compounds which may have harmful effects on humans and therefore require care during handling. The thermal conductivity of the grease may also decrease during the life of the apparatus. In addition, the assembly of the apparatus is slower due to the need to apply thermal grease to the correct contact surfaces.

### SUMMARY OF THE INVENTION

An object of the present invention is to solve the above-mentioned drawback and to provide a novel solution for removing a heat load from a semiconductor in an apparatus. This object is achieved with the apparatus of independent claim 1 and the method of independent claim 8.

The use of a part with a surface having protrusions that at least partly penetrate into a surface of another part makes it possible to ensure that the parts contacting each other have a sufficient contact in order to ensure that heat is efficiently transferred over the interface between the surfaces. Therefore sufficient heat conductivity can be accomplished by providing at least one of the surfaces with protrusions, and by bringing the two surfaces into an appropriate contact with each other. The result is a simple and fast production process.

Preferred embodiments of the invention are disclosed in the dependent claims.

### BRIEF DESCRIPTION OF DRAWINGS

In the following the present invention will be described in closer detail by way of example and with reference to the attached drawings, in which

Figure 1 illustrates a first embodiment of an apparatus,

Figure 2 illustrates a second embodiment of an apparatus,

Figure 3 illustrates a first embodiment of obtaining a thermal connection, and

Figure 4 illustrates a second embodiment of obtaining a thermal connection.

### DESCRIPTION OF AT LEAST ONE EMBODIMENT

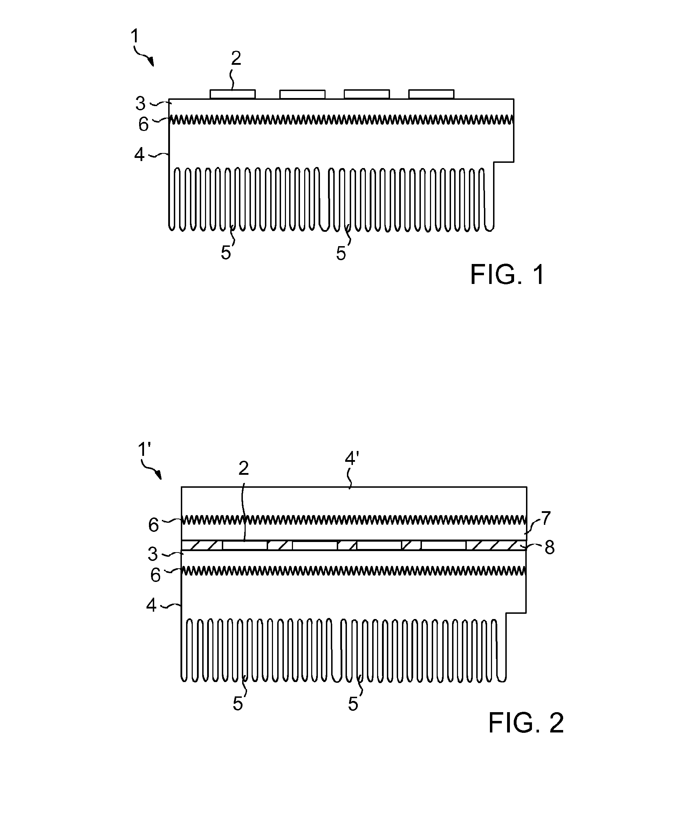

Figure 1 illustrates a first embodiment of an apparatus 1. The apparatus 1 includes at least one semiconductor 2, though in the illustrated example four semiconductors 2 are shown by way of example. The illustrated apparatus may be a part of a motor drive, such as a frequency converter.

The semiconductor 2 is attached to a base plate 3 which may be used for electrically connecting the semiconductor 2 to external devices. During use, the semiconductor device 2 generates a heat load that needs to be dissipated in order to avoid that the temperature of the semiconductor rises to an extent where malfunctions may occur. A surface of the base plate 3 is therefore in contact with a surface of an element 4 in order to forward the heat load generated by the semiconductor to the element 4.

In the example of Figure 1 the element 4 consist of a cooling element with fins 5. The element 5 therefore transfers the heat load from the semiconductor 2 into the surrounding air via the fins 5. Alternatively, it is possible to utilize a cooling element without fins. In that case, the cooling element may include a channel for a cooling fluid, for instance, in which case the heat load from the semiconductor 2 is transferred to the fluid by the cooling element. In such a solution, circulation of the fluid may ensure that the hot fluid is transferred away from the cooling element in order to replace the hot fluid with fluid that has cooled down in an external device, for instance.

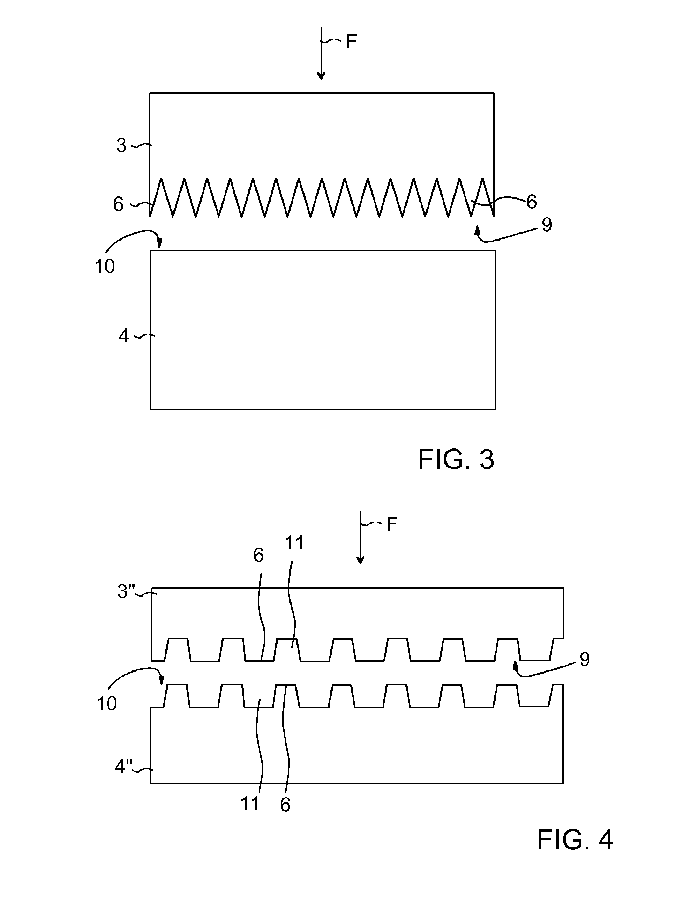

In order to ensure that the surfaces of the base plate 3 and the element 4 have a sufficient thermal contact, at least one of these surfaces is provided with a plurality of protrusions 6 that at least partly penetrate into the other one of said surfaces. This is illustrated in more detail in Figures 3 and 4.

Figure 2 illustrates a second embodiment of an apparatus 1'. The embodiment of Figure 2 is very similar to the one explained in connection with Figure 1. Therefore, the embodiment of Figure 2 will be explained in the following mainly by pointing out the differences between these embodiments.

In the embodiment of Figure 2, the semiconductor 2 or semiconductors are encapsulated into a semiconductor module, and the base plate 6 forms a part of this semiconductor module. A second plate 7, which may be similar to the base plate 6, is arranged on top of the semiconductor 2 and attached to the semiconductor 2. In addition, it is, by way of example, assumed that the space between the base plate 3 and the plate 7 is filled with a suitable material 8, such as a plastic material, in order to encapsulate the semiconductor 2 or the semiconductors into the semiconductor module.

The plate 7 has an upper surface contacting an element 4', which may be a conductor rail electrically connecting the semiconductor 2 to an external device. In addition, heat generated by the semiconductor 2 is transferred away from the semiconductor module via the element 4'. In order to ensure a sufficient thermal contact between a surface of the plate 7 and a surface of the element 4', at least one of these surfaces is provided with a plurality of protrusions 6 that at least partly penetrate into the other one of said surfaces. This is illustrated in more detail in Figures 3 and 4.

Figure 3 illustrates a first embodiment of obtaining a thermal connection. Such a solution may be used between the base plate 3 and the element 4 or between the plate 7 and the element 4', as illustrated in Figures 1 and 2. By way of example, the following explanation relates specifically to the interface between the base plate 3 and the element 4.

In the illustrated example, the surface 9 of the base plate 3 is provided with sharp protrusions 6. The protrusions 6 may consist of areas located between V-shaped elongated grooves that have been provided in substantially the entire surface area of the surface 9. Alternatively, the protrusions 6 may consist of a plurality of conical protrusions provided in substantially the entire surface area of the surface 9. In this example, the surface 10 of the element 4 is smooth.

When the base plate 3 is attached to the element 4, a force F is utilized to press the base plate 3 towards the element 4 until the sharp protrusions 6 at least partly penetrate into the surface 10 of the element 4. In this position, the base plate 3 and element 4 may be attached to each other with screws, for instance. Due to the protrusions 6 penetrating at least partly into the surface 10 of the element 4, excellent heat conductivity is achieved.

In order to make it easier for the protrusions 6 to penetrate into the opposite surface, the protrusions are preferably manufactured of a material which is harder than the opposite surface. One alternative is to utilize a Metal Matrix Composite (MMC) for the protrusions and copper for the opposite surface, for instance. The base plate 3 and element 4 may be manufactured entirely of such materials, or alternatively both or only one of the surfaces is covered by a layer of a suitable material.

Figure 4 illustrates a second embodiment of obtaining a thermal connection. The embodiment of Figure 4 is very similar to the one explained in connection with Figure 3.

In the embodiment of Figure 4, both surfaces 9 and 10 of the base plate 3" and the element 4" are provided with protrusions 6. In addition, the surfaces 9 and 10 are also provided with recesses 11 for receiving protrusions of the opposite surface. Therefore, the recesses need not be sharp and the force F needed to ensure that the protrusions 6 penetrate into the opposite surface (recesses 11) may be much smaller than in the embodiment of Figure 3. Excellent heat conductivity is achieved also with the embodiment of Figure 4.

It is to be understood that the above description and the accompanying figures are only intended to illustrate the present invention. It will be obvious to a person skilled in the art that the invention can be varied and modified without departing from the scope of the invention.

## Claims

1. An apparatus (1, 1'), comprising:
at least one semiconductor (2) arranged on a base plate (3, 3"), and
an element (4, 4") with a surface (10) arranged to contact a surface (9) of the base plate for receiving a heat load generated by said at least one semiconductor (2) device, **characterized in that**
at least one of said surfaces (9, 10) is provided with a plurality of protrusions (6) which at least partly penetrate into the other one of said surfaces (9, 10).

2. An apparatus according to claim 1, **characterized in that** said at least one surface (9) is provided with sharp protrusions (6) and said other surface is a smooth surface into which said sharp protrusions penetrate due to a force pressing said base plate and element towards each other.

3. An apparatus according to claim 1, **characterized in that** said at least one surface (9) is provided with protrusions (6) and said other surface is provided with recesses (11) for receiving said protrusions.

4. An apparatus according to one of claims 1 to 3, **characterized in that** the element (4, 4"), the base plate (3, 3") or both the element and the base plate comprise on said surfaces (9, 10) a cover layer which is softer than the material covered by said cover layer.

5. An apparatus according to one of claims 1 to 4, **characterized in that** the element (4) is a cooling element for transferring said heat load to the surrounding air or into a fluid flowing through said cooling element.

6. An apparatus according to one of claims 1 to 4, **characterized in that** said element is a conductor rail electrically connecting said at least one semiconductor (2) to an external device.

7. An apparatus according to one of claims 1 to 6, **characterized in that** said at least one semiconductor (2) is encapsulated into a semiconductor module (3, 7, 8), and said base plate (3) forms a part of said semiconductor module.

8. A method of thermally connecting a surface (9) of a semiconductor (2) base plate (3, 3") to a surface of an element (4, 4") receiving a heat load generated by said semiconductor (2), **characterized in that** the method comprises:
providing at least one of said surfaces (9, 10) with a plurality of protrusions (6),
arranging said surfaces (9, 10) to contact each other, and
attaching said base plate (3, 3') and said element (4, 4") to each other such that said plurality of protrusions (6) on the at least one surface (9, 10) at least partly penetrate into the other one of said surfaces (9, 10).
